# EUROPEAN PATENT APPLICATION

(11) **EP 2 787 795 A1**
(43) Date of publication of application: **08.10.2014**
(21) Application number: 12852663.9
(22) Date of filing: 11.04.2012
(51) Int. Cl.: H05H 1/34, H05H 1/50

(54) **ANODE ASSEMBLY OF A VACUUM-ARC CATHODE PLASMA SOURCE**

(30) Priority: 29.11.2011 UA 2011014090
(71) Applicant: National Science Center Kharkov Institute Of Physics and Technology (NSC KIPT), Kharkov 61108 (UA)
(72) Inventor: VASYLIEV, Volodymyr Vasilievich, Kharkov 61089 (UA); STRELNYTSKIY, Volodymyr Evgenievich, Kharkov 61098 (UA)
(74) Representative: Sloboshanin, Sergej
(86) International application number: PCT/UA2012/000042
(87) International publication number: WO 2013/081569

(57) **Abstract**

The invention relates to the vacuum arc cathode plasma source anode unit. The invention can be used predominantly as a part of linear vacuum arc cathode plasma source with micro particle filtering together with various vacuum arc evaporators and plasma guides for plasma transport. The anode unit includes an anode encircled by the electromagnetic focusing coil and shaped as a tube segment. Inside, the anode contains an electromagnetic deflection coil which is placed coaxially to it in the electro conductive shell and whose magnetic field is directed opposite to the magnetic field of the electromagnetic focusing coil. Inside, the deflection coil contains a constant deflection magnet which is placed on its axis close to the butt end directed towards the anode inlet and whose magnetic field is co-directed with the magnetic field of the electromagnetic deflection coil. The anode unit characterized in that it includes an additional constant magnet which is placed inside the electromagnetic deflection coil on its axis close to the butt end directed opposite to the anode inlet and whose magnetic field is directed opposite to the magnetic field of the constant deflection magnet. The positive terminal of the arc power supply source is connected both to the anode through the winding of the electromagnetic focusing coil and to the shell of the electromagnetic deflection coil through its winding. Due to this, the dynamic equilibrium of plasma flows traveling in the gap between the inner anode surface and the outer surface of the electromagnetic deflection coil shell is achieved. This significantly reduces plasma losses.

## Description

### FIELD OF THE INVENTION

The invention relates to the technology of obtaining plasma flows in electric arc plasma sources. The proposed anode unit can be used predominantly as a part of linear vacuum arc cathode plasma source with microparticle filtering together with various vacuum arc evaporators and plasma guides for plasma transport.

### BACKGROUND OF THE INVENTION

A known anode unit [see Reference 1 at the end of the description] of linear vacuum arc cathode plasma source includes an anode shaped as a tube segment encircled by the electromagnetic coils which form a sectioned solenoid consisting of a minimum of three separate sections with each connected to a separate power supply. This unit includes a microparticle reflector designed in the form of a disc and fixed inside the tube segment on its axis by the conductive rods attached to its inner wall to ensure electrical and thermal contact. The microparticle reflector within the anode unit shall be called a screen.

A sectioned solenoid placed outside the anode is used to create the necessary magnetic field configuration that ensures maximum encircling of the screen by the magnetic field lines crossing a considerable part of the evaporable cathode butt end surface without crossing the anode. However, a part of magnetic field lines in the cathode area around the axis finds its way onto the screen. As a consequence, significant losses of plasma propagating along the magnetic field occur. High arc current runs straight to the screen. When the arc current is more than 70 A, the screen overheating occurs. This can result in fixation of the arc to an overheated part of the screen and to melting or destruction of the screen. Moreover, considerable plasma losses as a result of magnetic field weakening around the screen occur. This causes plasma drift towards the anode and its deposition on the anode surface.

The nearest prior art (herein called a "prototype") for the device claimed herein is a vacuum arc cathode plasma source anode unit [see Reference 2 at the end of the description]. The unit includes an anode shaped as a tube segment encircled by an electromagnetic focusing coil. Inside, the anode contains an electromagnetic deflection coil placed coaxially to it in the electro conductive shell. Inside, the electromagnetic deflection coil contains a constant cylindrical deflection magnet placed on its axis close to the butt end directed towards the anode inlet.

The electromagnetic deflection coil generates a magnetic field directed opposite to a magnetic field generated by the electromagnetic focusing coil. The magnetic field of the permanent magnet is co-directed with the magnetic field generated by the electromagnetic deflection coil on its axis. The electromagnetic deflection coil together with the permanent magnet forms a so called "magnetic island". The permanent magnet allows reducing a size of the "magnetic island" without reduction of the deflection magnetic field intensity and thereby allows reducing a size of the vacuum arc cathode plasma source. The "magnetic island" reduces the losses of plasma traveling in the paraxial area along the axis to the screen which is a butt end wall of the abovementioned shell.

However, despite the presence of such "magnetic island", plasma losses are still significant. A considerable part of plasma flows coming out of the arc cathode spots traveling in the central (paraxial) cathode area to a rather strong magnetic field generated both by the electromagnetic deflection coil and the permanent magnet encircles the "magnetic island" and finds the way to its rear surface. This results in losses of plasma flows on the rear surface of the "magnetic island". The plasma flows coming out of the arc cathode spots in the peripheral area of the cathode butt end travel in the magnetic field created predominantly by the electromagnetic focusing coil and encircle the deflection magnetic coil virtually without reaching its rare surface. However, plasma losses across the magnetic field to the anode walls are increased due to both the magnetic field gradient directed towards the lateral surface of the electromagnetic deflection coil and the formation of a magnetic mirror for electrons around this coil.

The object of the invention is to improve the anode unit of a vacuum arc cathode plasma source to reduce the losses of plasma during its transport inside the unit. The improvements should be made by changing the magnetic field configuration inside the anode and by regulating magnetic field intensities created by the electromagnetic coils depending on the arc current flowing through the electro conductive elements of the anode unit.

### SUMMARY OF THE INVENTION

The problem is solved in the proposed anode unit of a vacuum arc cathode plasma source which, like the anode unit assumed as the prototype, in preferred embodiments includes the anode shaped as a tube segment encircled by the electromagnetic focusing coil. Inside, the anode contains an electromagnetic deflection coil placed coaxially to it in the electro conductive shell. Inside, the electromagnetic deflection coil contains a permanent cylindrical magnet placed on its axis close to the butt end directed towards the anode inlet. The electromagnetic deflection coil is used to create a magnetic field directed opposite to the magnetic field of the electromagnetic focusing coil. The magnetic field of the permanent magnet is co-directed with the magnetic field generated by the electromagnetic deflection coil on its axis.

Unlike the prototype, the proposed anode unit includes an additional permanent magnet placed inside the electromagnetic deflection coil on its axis close to the butt end directed opposite the anode inlet. The magnetic field of this magnet is directed opposite to the magnetic field of the permanent deflection magnet. The positive terminal of an arc power supply source is electrically connected both to the anode through the electromagnetic focusing coil and to the shell of the deflection coil through its winding.

The electromagnetic deflection coil winding can preferably be made of a water-cooled pipe. In so doing, the wind of the abovementioned coil close to its butt end directed towards the anode inlet should have a thermal contact with the shell.

Let us consider how the losses of plasma during its transport inside the anode are reduced in the proposed anode unit.

The additional permanent magnet together with the magnetic field of the electromagnetic focusing coil ensures deflection of a considerable part of magnetic field lines of the electromagnetic deflection coil and the permanent deflection magnet towards the anode outlet. This prevents the magnetic field of the butt end surface of the coil shell directed towards the anode outlet from crossing by the abovementioned magnetic field lines. As a result, plasma jets emitted by the arc cathode spots which travel in the central (paraxial) cathode area and propagate along the magnetic field lines encircling both the electromagnetic deflection coil and the shell come out of the anode outlet without reaching the shell butt end directed towards this outlet. According to the results of previous experiments, this increases the output ion current by one-third.

The abovementioned electrical connection of the electromagnetic focusing and deflection coil winds ensures regulation of directions for the magnetic fields of coils depending on the arc current flowing either through the anode or through the abovementioned shell. Such regulation ensures changing the total magnetic field so that it deflects plasma flows from the inner surface of the anode when the arc current runs through the anode and from the outer surface of the shell when the arc current runs through this shell. Due to this, in the proposed anode unit the dynamic equilibrium of plasma flows traveling in the gap between the anode inner surface and the electromagnetic deflection coil outer surface is achieved. This significantly reduces plasma losses in the anode unit.

The electromagnetic deflection coil winding made of a water-cooling pipe and connected to the shell as described above allows using the electromagnetic deflection coil shell as a part of the anode.

### BRIEF DESCRIPTION OF DRAWING OF THE INVENTION

The nature of invention is explained by an attached drawing that illustrates the inventive device for implementation of the inventive method.

### DETAIL DESCRIPTION OF PREFERRED EMBODIMENTS OF THE INVENTION

While the invention may be susceptible to embodiment in different forms, there are described in detail herein below specific embodiments of the present invention with the understanding that the present disclosure is to be considered an exemplification of the principles of the invention and is not intended to limit the invention to that as illustrated and described herein.

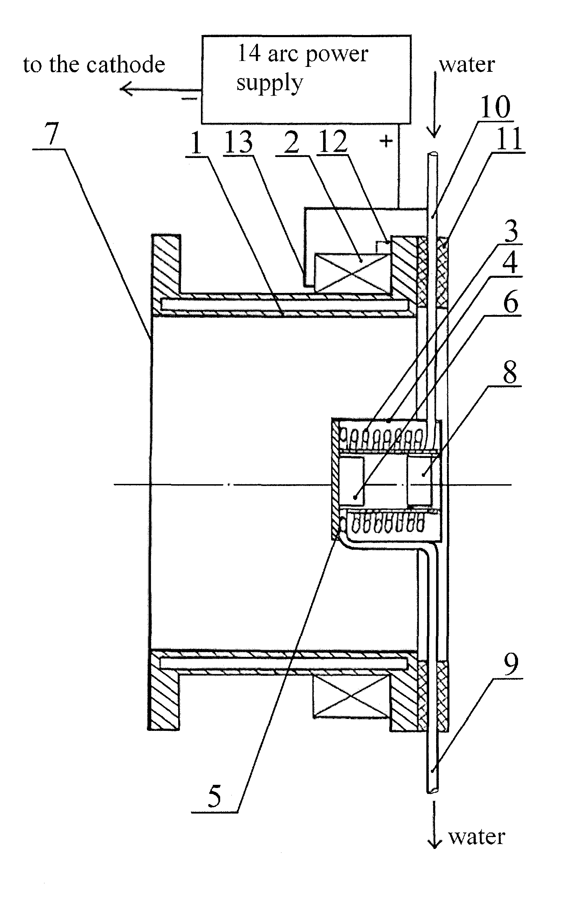

Referring to the attached drawing, let us consider an exemplary preferred embodiment of the proposed anode unit for a filtered vacuum arc cathode plasma linear source.

The proposed anode unit includes: a water-cooling anode 1 shaped as a tube segment made of a non-magnetic stainless steel with flanges. The anode 1 is characterized with a longitudinal axis and has an inlet 7. An isolation ring 11 is coupled to the anode 1 at an outlet thereof situated opposite to the inlet 7. An electromagnetic focusing coil 2 is externally mounted on and encircles the anode 1. The electromagnetic focusing coil 2 has a beginning turn end 13 and a last turn end 12. An electromagnetic deflection coil 3 encapsulated in an electro conductive shell 4 is coaxially mounted inside the anode 1 along the longitudinal axis. The coil 3 includes: a beginning turn 5 facing and being closest to the inlet 7; a proximal butt end being proximal to the inlet 7; a distal butt end being distal from the inlet 7; terminal winding ends 9 and 10. This electromagnetic deflection coil is made of a water-cooling copper pipe. The shell 4 is connected to the beginning turn 5 of the coil 3 to ensure electrical and thermal contact there between. A permanent deflection magnet 6 is mounted inside the electromagnetic deflection coil 3 along the longitudinal axis predeterminedly close to the proximal butt end of the coil 3 directed towards the anode inlet 7. An additional permanent magnet 8 is mounted inside the electromagnetic deflection coil 3 along the longitudinal axis similarly to the magnet 6, but closer to the distal butt end of coil 3 directed opposite to the inlet 7. The magnetic field of the additional permanent magnet 8 is directed opposite to the magnetic field of the permanent deflection magnet 6. The electromagnetic deflection coil 3 is fixed inside the anode 1, using the terminal ends 9 and 10 thereof, which are mounted along a diameter of the isolation ring 11 and fixed, preferably vacuum tight, to the outer surface of the ring. The anode 1 is electrically connected to the last turn end 12 of the electromagnetic focusing coil 2. The beginning turn end 13 is connected to a positive terminal of an arc power supply source 14 and to the terminal winding end 10 of the electromagnetic deflection coil 3, whose beginning turn 5 is connected to the shell 4.

Let us consider the operation of the inventive anode being a part of a vacuum arc cathode plasma source with an evaporator and a plasma guide.

On the inlet side, the anode unit is attached to a vacuum arc evaporator with a cathode encircled by a cathode electromagnetic coil. On the outlet side, it is attached to a plasma guide encircled by an outlet electromagnetic coil (not shown in the drawing). Due to these two coils, a constant transport magnetic field can be created inside the anode unit with magnetic field being convex in the direction from the anode's axis.

After the arc discharge ignition is initiated on the evaporable cathode butt end surface (not shown in the drawing), plasma jets coming out of the arc cathode spots which travel along the evaporable cathode surface move along the transport magnetic field lines. Depending on the position of the cathode spots in relation to the cathode axis, the arc current can travel either through the anode 1 or through the shell 4 of the electromagnetic deflection coil 3, or simultaneously through the anode 1 and the shell 4.

In case when the cathode spots travel in the paraxial area of the cathode butt end, plasma jets coming out of these spots will travel reasonably close to the inner wall of the anode 1. Due to anode connection to the positive terminal of the arc power supply source 14 through the ends 13 and 12 of the electromagnetic focusing coil 2, the magnetic field which deflects plasma flows from the anode 1 wall is intensified during the arc current flow through the anode. As a result, plasma losses to the anode wall are sharply reduced.

In case when the arc cathode spots travel in the paraxial area of the cathode butt end, plasma jets coming out of these spots will encircle the shell 4 reasonably close to its surface. In so doing, virtually all the arc current can travel through the shell. However, due to connection of the shell 4 to the positive terminal of the arc power supply source 14 via the deflection electromagnetic coil 3, the magnetic field that ensures deflection of plasma flows from the lateral wall of the shell is intensified during the arc current flow through the shell and, therefore, through the coil 3. The additional permanent magnet 8 ensures deflection of a considerable part of magnetic field lines created by the electromagnetic coil 3 and the permanent magnet 6 towards the anode unit outlet. As a result, plasma losses to the rear wall of the shell 4 are reduced. During operation of the anode unit 1, the deflection coil 3 made of a copper pipe is cooled by water. The beginning turn 5 of the coil 3 connected to the shell 4 ensures effective cooling of the shell. The anode is effectively cooled as well. This extends operational lifespan of the anode unit.

### INDUSTRIAL APPLICABILITY

The proposed anode unit was tested with the following parameters: the anode inner diameter - 226 mm; the anode length - 155 mm; the outer deflection magnet coil diameter - 68 mm; the deflection electromagnetic coil length - 60 mm; the outer diameter of the deflection electromagnetic coil shell - 74 mm; the distance from the inlet anode opening to the butt end of the shell of the deflection electromagnetic coil - 100 mm. Testing of the anode unit together with a vacuum arc evaporator and a cylindrical consumable titanium cathode showed that the total output ion current was not less than 6 A at the arc current of 100 A. This is at least 1.5 times greater than the output current of the anode unit assumed as the prototype at the same arc current.

### REFERENCES CITED

1. I.I. Aksenov, V.M. Khoroshikh. Filtering shields in vacuum arc plasma sourses // Proc. of the 6th International Simposium on Trends and New Application of Thin Films (TATF '98), Regensburg, Germany, March 1998, p. 283-286.
2. A. Kleiman, A. Marques, R.L. Boxman. Performance of a magnetic islend macroparticle filter in a titenium vacuum arc // Plasma Sources Sci. Technol. 17, 2008, p. 1-7 (prototype).

## Claims

1. An anode unit of a vacuum-arc cathode plasma power supply source, said unit comprising: an anode enveloped by an electromagnetic focusing coil and shaped as a tube segment, inside the segment and coaxially thereto is encapsulated in an electro-conductive shell an electromagnetic deflection coil, the magnetic field of which is directed oppositely to a magnetic field of the electromagnetic focusing coil, inside the deflection coil on its axis, nearby its end and facing an inlet of the anode is arranged a permanent deflection magnet, the magnetic field of which is co-directed to the magnetic field of the electromagnetic deflection coil, ***characterized in that**,* it comprises an additional permanent magnet, arranged inside the electromagnetic deflection coil on its axis, nearby its distal end facing the direction opposite the inlet of the anode, the magnetic field of the additional magnet is directed oppositely to the magnetic field of the permanent deflection magnet, wherein the positive pole of the power supply source of the arc is electrically connected to the anode through the winding of the electromagnetic focusing coil as well as to the shell of the deflection coil through its winding.

2. The anode unit according to claim 1, ***characterized in that*** the winding of the electromagnetic deflection coil is made of an electro-conductive pipe cooled by water, wherein the turn of the winding nearby its end facing the inlet of the anode has a thermal contact with the shell.
